# EUROPEAN PATENT SPECIFICATION

(11) **EP 1 261 554 B1**
(45) Date of publication and mention of the grant of the patent: **20.10.2004**
(21) Application number: 00974749.4
(22) Date of filing: 28.11.2000
(51) Int. Cl.: C03C 3/04, C03C 3/11, C03B 19/14, C01B 21/087, C01B 21/082, C23C 16/30, G02B 6/10

(54) **Method for fabricating SiON-waveguides**
Verfahren zur Herstellung von SiON-Wellenleiter
Procédé de fabrication de guides d'ondes optiques à base de SiON

(30) Priority: 29.02.2000 EP 00810163
(43) Date of publication of application: 04.12.2002
(73) Proprietor: International Business Machines Corporation, Armonk, NY 10504 (US)
(72) Inventor: BEYELER, René, CH-8306 Bruettisellen (CH); BLÖCHL, Peter, D-38640 Goslar (CH); BONA, Gian-Luca, CH-8908 Hedingen (CH); GERMANN, Roland, W., CH-8855 Wangen (CH); HORST, Folkert, CH-8038 Zurich (CH); OFFREIN, Bert, J., CH-8135 Langnau (CH); SALEMINK, Huub, L., NL-6561 Groesbeek (NL); WIESMANN, Dorothea, W., CH-8038 Zurich (CH)
(74) Representative: Toleti, Martin
(86) International application number: PCT/IB2000/001763
(87) International publication number: WO 2001/064594

(56) References cited:
- WO-A-99/44937
- US-A- 6 023 093
- US-A- 6 156 653
- HUBNER J ET AL: "Strong Bragg gratings induced with 248 nm light in buried silicon oxynitride waveguides" BRAGG GRATING, PHOTOSENSITIVITY, AND POLING IN GLASS FIBERS AND WAVEGUIDES: APPLICATIONS AND FUNDAMENTALS. TECHNICAL DIGEST. POSTCONFERENCE EDITION, PROCEEDINGS OF BRAGG GRATINGS, PHOTOSENSITIVITY, AND POLING IN GLASS FIBERS AND WAVEGUIDES: APPLICATI, 26 October 1997 (1997-10-26), pages 346-350, XP000987165 1997, Washington, DC, USA, Opt. Soc. America, USA ISBN: 1-55752-516-1
- ARNOLDBIK W M ET AL: "Dynamic behavior of hydrogen in silicon nitride and oxynitride films made by low-pressure chemical vapor deposition" PHYSICAL REVIEW B (CONDENSED MATTER), 15 AUG. 1993, USA, vol. 48, no. 8, pages 5444-5456, XP000979362 ISSN: 0163-1829
- HABRAKEN F H P M ET AL: "Hydrogen in low-pressure chemical-vapor-deposited silicon (oxy)nitride films" JOURNAL OF APPLIED PHYSICS, 15 JAN. 1986, USA, vol. 59, no. 2, pages 447-453, XP000979361 ISSN: 0021-8979
- ARNOLDBIK W M ET AL: "Deuterium diffusion into plasma-deposited silicon oxynitride films" APPLIED SURFACE SCIENCE, JAN. 1994, NETHERLANDS, vol. 74, no. 1, pages 103-113, XP000987037 ISSN: 0169-4332
- GERMANN R ET AL: "Silicon-oxynitride layers for optical waveguide applications" SILICON NITRIDE AND SILICON DIOXIDE THIN INSULATING FILMS. PROCEEDINGS OF THE FIFTH INTERNATIONAL SYMPOSIUM (ELECTROCHEMICAL SOCIETY PROCEEDINGS VOL.99-6), PROCEEDINGS OF THE FIFTH INTERNATIONAL SYMPOSIUM ON SILICON NITRIDE AND SILICON DIOXIDE THIN I, pages 169-181, XP000987166 1999, Pennington, NJ, USA, Electrochem. Soc, USA ISBN: 1-56677-228-1

## Description

### Field of the Invention

The present invention relates to a method for fabricating SiON-optical waveguides.

### Background of the Invention, Prior Art

High-bandwidth communication today relies increasingly on optical fibers and optical components for signal enhancement, signal-routing, adding and dropping information. The requirement for high capacity communication systems has led to the use of optical waveguides. An optical waveguide consists of a core made of some high-refractive index material and a cladding of a low- refractive-index material surrounding the core. In traditional optical-waveguide technology, the core and cladding are made of doped silica glass, where the refractive index contrast, i.e., the difference of the refractive index of the core layer relative to the cladding layers, is achieved by a doping profile, e.g., using P-doping or Ge-doping. In order to fabricate optical components in a cost-effective way in mass production, it is desirable to increase the areal density. This can be achieved with the SiON technology. A review on planar waveguide technology is given, e.g., in "Silica-based optical integrated circuits" by Y.P. Li and C.H. Henry; IEEE Proc.- Optoelectron., Vol. 143, No. 5, October 1996, pp. 263-280.

In order to increase the areal density compared to traditional technology, smaller bending radii are required. Smaller bending radii, however, require a stronger guiding of the optical modes than in a straight waveguide or fiber. This is achieved by increasing the refractive index contrast between core and cladding. An example for a method for increasing the index of refraction of a glassy material is given in US-A-5,500,031, wherein the material is treated with hydrogen under the application of heat. However, the maximum doping levels with P, B, Ge or other dopants in SiO₂ (silica) limit the maximum achievable index contrast and hence a minimal attainable bending radius in the waveguide exists. In both conventional fiber and planar Ge-silica (SiO₂) there is an index contrast ranging from 0.002 up to 0.006. This allows a curvature radius of typically 15 mm. The index contrast in SiON technology is typically 0.02 (i.e., 3x to 10x higher) and allows for a curvature radius down to 1.5 mm. This corresponds to an increase in areal density of 100x. A good compromise between the minimum bending radius and coupling losses to the standard fiber and the necessary difference in the material composition between core and cladding resulting therefrom can be obtained, e.g., with an effective refractive-index contrast around 0.02.

If the cladding is made of silica, i.e., SiO₂, which has a refractive index of 1.45, a material having a refractive index near 1.51 is desired for the core. Waveguides with such a high index contrast can be fabricated with silicon-oxinitride (SiON) core layers. An example for the use of SiON as a material for fabricating waveguides is given in US-A-5,416,861.

Owing to the nitrogen "doped" silicon-oxide compound, the refractive index can be adjusted in a very flexible way to match other design criteria such as, e.g., achievable dimensions. A relatively high effective lateral contrast in refractive index can be used which is approximately 10 x higher than that used for Ge-doped SiO₂ waveguides. This allows a 10 x smaller radius of curvature (1.5 mm) to be used in circuit layouts.

A typical fabrication technique is to deposit silicon oxinitride by means of a PECVD process using silane (SiH₄), nitrous-oxide (N₂O), and ammonia (NH₃) as gaseous precursors. The resulting material, however, has a large hydrogen concentration. Hydrogen is incorporated in the form of hydroxyl groups, Si-H groups and NH- and NH₂-fragments. These groups and fragments introduce additional absorption into the optical transmission characteristic of the silicon oxinitride. The first overtone of the NH-induced absorption lies at 1510 nm and overlaps with the spectral window which is used for optical signal transmission and which extents from 1540 nm to 1570 nm, hereinafter simply referred to as the optical transmission window. This window has been chosen for optical transmission due to the fact that the optical transmission losses are minimal around 1550 nm (due to purity of fabrication) and that for all-optical amplifiers in fiber networks (avoiding electrical-optical conversions) the only currently available amplifiers are based on Er (Erbium)-doping of SiO₂ fibers and the resultant amplification window is limited to 1540-1570 nm. Therefore, the accepted standard for the optical telecommunication frequencies has been assigned to this window (cf. "Review of Rare Earth Doped Fiber Lasers and Amplifiers" by P. Urquhart; IEEE Proc., Vol. 135, Pt. J, No. 6, December 1988, pp. 385-407.

The above mentioned NH-absorption results in often unacceptably large losses for viable products. The hydrogen concentration and with it the resulting absorption losses are therefore currently reduced by a high-temperature annealing process as described, e.g., in MRS Proceedings Book of the 1999 Spring Meeting of the MRS Materials Research Society, "Materials Research Society (MRS) Spring Meeting 1999, 5-8 April 1999, Paper BB.8.3, Symposium BB on Multicomponent Oxides", MRS Proceedings Volume 574, pp. 255-260, 1999 (ISBN 1-55899-481-5). The process consolidates the SiON material, and removes hydrogen from the N-H bond in the form of H₂ and H₂O. In conventional SiON material (SiON:H), the losses are reduced to lower values by higher anneal temperatures or longer anneal durations, but both routes bear the risk of introducing unwanted defect-scattering or crystallization. A further negative side effect of the high-temperature annealing is the introduction of anisotropic stress, caused by the difference in thermal expansion coefficients between the silicon substrate and the material of the waveguide. The stress correlates with the temperature difference between room temperature and the highest annealing temperature or a material-specific temperature close to its annealing point, whichever is lower. The stress gives rise to birefringence and polarization-dependent transmission characteristics and is not desired for most applications.

It is known in the art of fiber manufacturing to use deuterium in place of hydrogen to produce glass having a low hydroxyl group (-OH) content. The hydroxyl group normally present in glass produced in the presence of hydrogen is replaced by the deuterium containing ion OD⁻. Absorption peaks normally caused by the presence of the hydroxyl ions are shifted to longer wavelengths at which the absorptions are not troublesome when the waveguide is used to transmit light in the band of approximately 7,000 Å. Thus, US-A-3,791,714 discloses the production of a SiO₂-waveguide by a flame hydrolysis process using deuterium gas or a deuterium compound gas which is passed through a liquid containing a silicon compound such as silicon tetrachloride. The resulting vapor is burned at high temperatures (about 1800°C) to deposit a film of silicon dioxide on a rotating mandrel, resulting in a "soot" deposit that contains OD-bonds instead of the usual OH-groups.

US-A-5,872,387 discloses semiconductor devices, including MOS devices, that are treated with deuterium to improve their operational characteristics. The process comprises a step of passivating the device with deuterium by disposing molecular, atomic or ionic deuterium in the areas of the device in which protection against hot carrier effects is desired. The deuterium is covalently bonded with atoms in this area so as to be stable incorporated.

A plate plastics optical waveguide is described in US-A-5,062,680 which includes a core portion composed of a polymer containing a deuterium atom or a halogen atom, and a clad portion surrounding the core portion, the clad portion being composed of a polymer having a refractive index lower than that of the core portion.

While US-A-5,872,387 only describes a post-fabrication passivation in a heated, deuterium gas-enriched atmosphere, and US-A-5,062,680 uses a polymer containing deuterium to produce the optical waveguide, the main disadvantage of US-A-3,791,714 is the fact that the optical waveguide prepared according to the process given therein still contains hydroxyl groups and is only applicable to manufacture waveguides in the form of fibers.

Accordingly, there is still a need for slab optical waveguides based on SiON material having extreme small optical losses and very low mechanical stress.

### Summary of the Invention

It is an object of the present invention to provide silicon-oxinitride (SiON) layers for applications as planar optical waveguides having extreme low optical losses in the region of operation.

It is also an object of the present invention to provide a low-temperature process to manufacture such planar optical waveguides.

It is a further object of the present invention to propose a technique to manufacture such waveguides in a low-cost, mass-fabrication technology.

It is still a further object of the present invention to provide optical waveguides that show low mechanical stress and a significantly reduced stress-related birefringance.

Still another object of the present invention is the provision of silicon-oxide based optical waveguides that could be integrated into conventional CMOS technology.

These and other objetcs and advantages are achieved by the method claimed in claim 1.

Preferred embodiments of the invention are described in the dependent claims.

### Brief Description of the Drawings

The invention will be described in more detail hereinafter in connection with the drawings, in which
- Fig. 1: is an infrared spectrum showing the NH-absorption band of conventional SiON:H material as compared to the SiON:D material prepared by the method according to the invention;
- Fig. 2: shows the slab propagation loss of SiON:D as compared to the SiON:H material annealed according to the state of the art;
- Fig. 3: depicts the compressive stress as a function of temperature for state of the art material as compared to the material prepared by the method according to the invention; and
- Fig. 4: shows a plot of the estimated birefringence dependent on compressive stress.

### Detailed Description of the Preferred Embodiment

Silicon-oxinitride (SiON) layers can function as planar optical waveguides in the 1550-nm wavelength region. The optically guiding SiON waveguide core layer has a relatively high refractive index of 1.500 and is sandwiched between two silicon- oxide cladding layers with a lower refractive index of 1.450. The SiON layer is deposited by PECVD using silane, nitrous oxide and ammonia as gaseous precursors. Waveguide bends with a radius of curvature as small as 1.5 mm can be realized because of high refractive index difference achievable between core and cladding layers. This allows the fabrication of compact, relatively complex integrated optical waveguide devices.

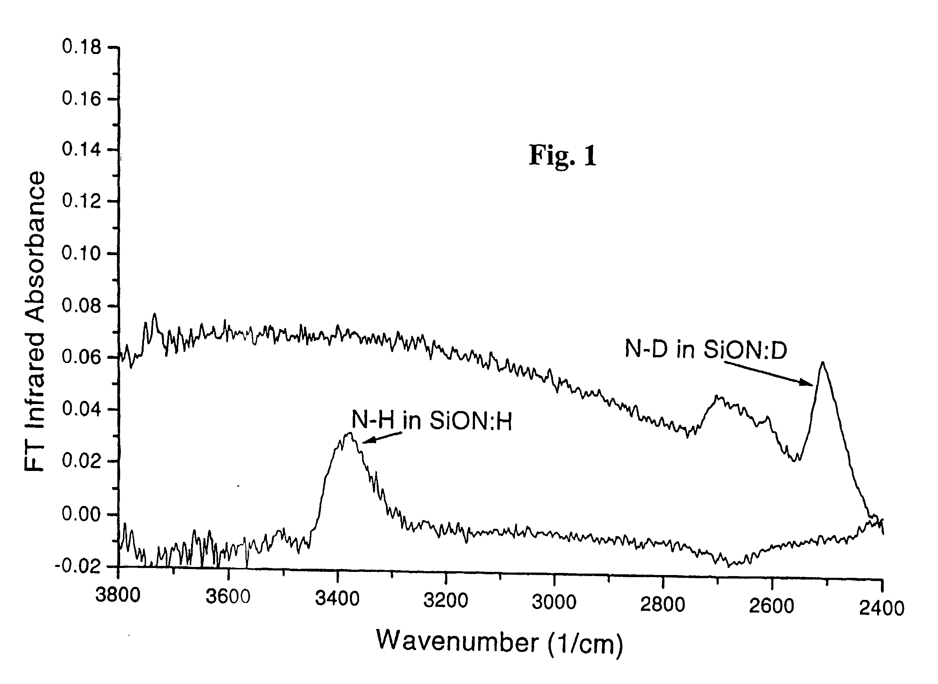

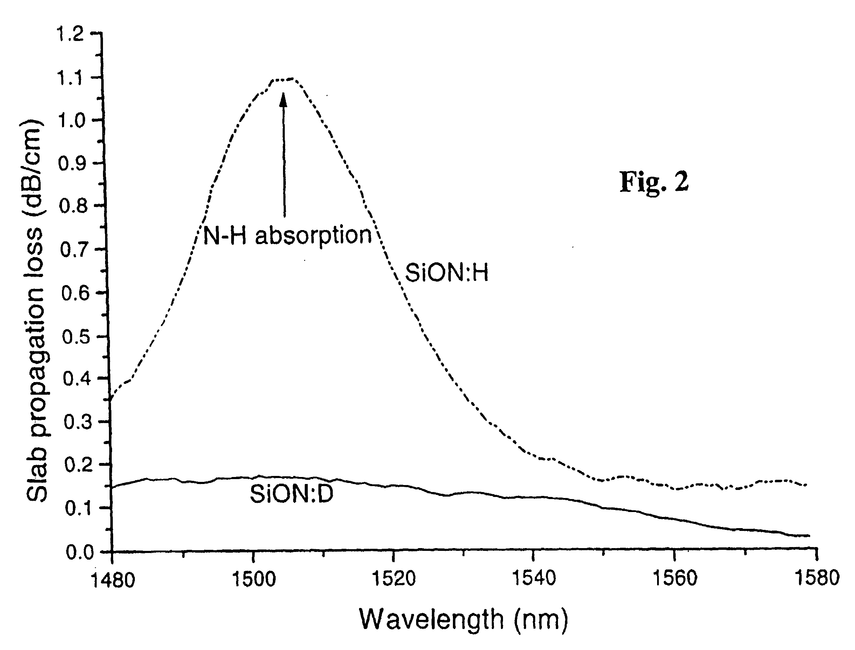

Owing to the hydrogenated precursors, the conventional, state of the art SiON layers (in the following called SiON:H) contain a large number of N-H bonds with their intrinsic infrared absorption at a wave number of 3350 cm⁻¹. The first overtone of this frequency is found at a wavelength of 1510 nm and its low-energy tail leads to an unwanted absorption loss in the wavelength region of interest (1545 to 1565 nm). Fig. 1 shows a typical absorption spectrum of a state of the art planar slab waveguide structure with an as-deposited SiON core layer (SiON:H; lower curve). A typical loss for unannealed SiON:H material is 10 dB/cm at 1510 nm and 1.0 - 1.2 dB/cm at 1550 nm (a factor of 10x higher than annealed material). The N-H bonds can be largely removed by annealing the SiON layers in an atmospheric nitrogen flow at a temperature of approximately 1140°C. The peak losses at 1510 nm then decrease to a value of 1.0 dB/cm, and the losses between 1545 and 1565 nm decrease to typical values of 0.15 ± 0.05 dB/cm what is shown in Fig. 2.

However, this high-temperature annealing process is an expensive manufacturing step which, in addition, slows down the wafer turnaround time. Moreover, stress build-up follows upon cooling down the relaxed layers from high-temperature, due to mismatched thermal expansion. The induced stress effects result in stress- related polarization dependence (birefringence). In addition to that, since the waveguide fabrication is a "high-temperature" process, only special substrate materials can be used which are able to stand these high temperatures.

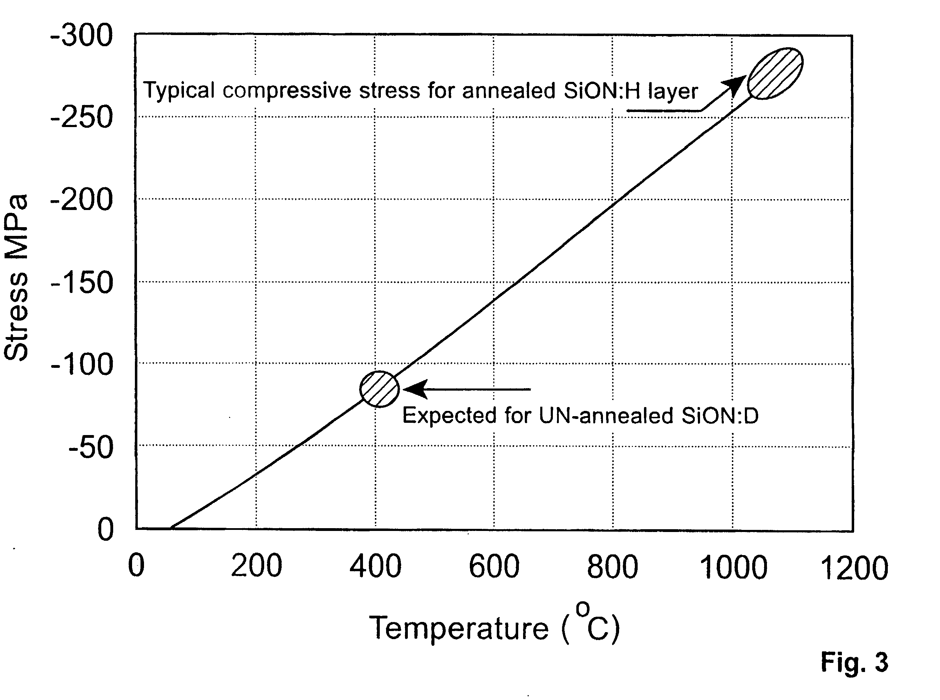

The present invention therefore proposes a "low-temperature" process for the manufacture of planar slab optical waveguides based on SiON material by using a deuterated SiON material (in the following called SiON:D). "Low temperature" here means that the foreseen maximum temperature of all process steps is in the range of 550 - 850°C, including densification steps and tuning of mechanicak stress. A "densification window" of 550 - 850°C might also be useful to stabilize the SiON:D properties. By using SiON:D material, the above mentioned anneal cycle at 1400°C (taking 22 hours) is avoided. Thus, the work-flow is simplified and a wider process latitude is given as the use of a wider temperature window is allowed. Moreover, the proposed method offers the possibility to integrate the optical waveguides into a conventional CMOS process for further hybrid integration. In addition to that, low mechanical stress in the oxidic layer stack can be achieved, the estimated lowering of compressive stress in SiON:D material is by a factor 3,5 from about -270 to -80 MPa (cf. Fig. 3). The typical value for SiON:H material is -120 MPa (as-grown) and -270 MPa (after 1145°C anneal). In contrast to that the value for SiON:D material according to the invention is -115 MPa (as grown), no anneal is necessary. The calculated unannealed SiON:D value of - 80 MPa shown in Fig. 3 is based on best estimates on the time the invention was made, the currently cited value is based on three SiON:D wafers with a value of -115 +/- 10 MPa. Thequoted stress values pertain to planar SiON:D and planar SiON:H layers on SiO₂ (lower cladding) base layers. For a full waveguide device, these SiON:X layers (X = H, D) are covered with a top-cladding SiO₂ layer to form an oxidic tri-layer. This overgrowth of SiON:X has the effect of making the oxidic sandwich mechanically more symmetric and hence lowers the residual stress and thus the stress-related birefringence.

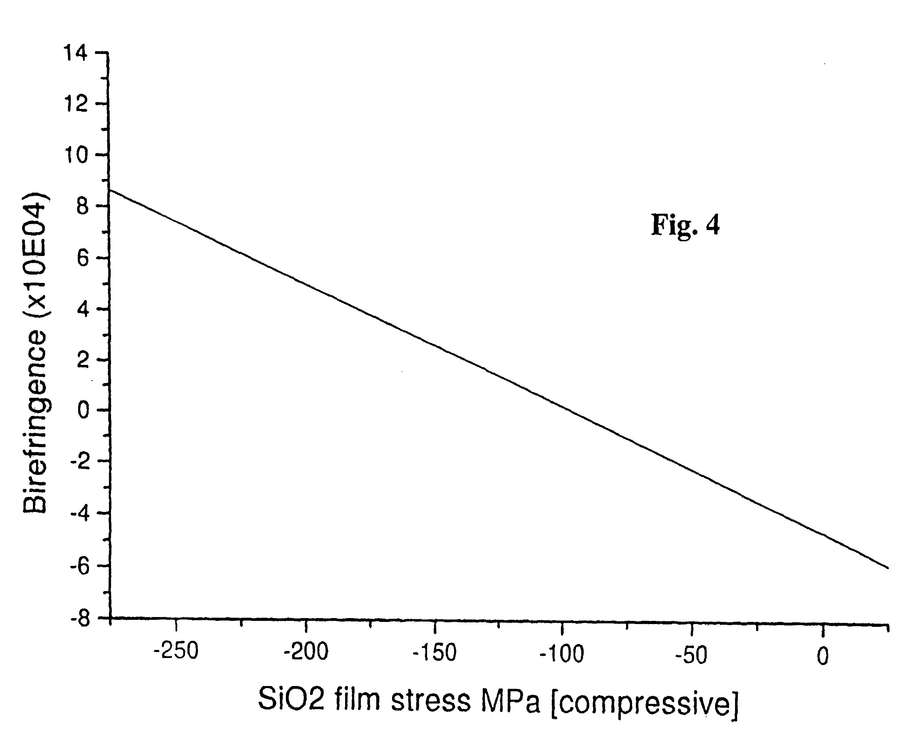

An estimate of this birefringence is shown in Fig. 4, estimating that the SiON:X trilayer waveguide devices of the present invention will have zero-birefringence (or polarization independent) at a compressive stress of -80 to - 100 MPa. It is also noted that an ultimative slight compressive stress (about -50 MPa) is probably advatageous for a multi-layered device in order to remain mechanically intact, because a lower or tensile stress value might easily lead to delamination, peeling off and structural insufficiency. Thus the SiON:D according to the present invention offers far better mechanically tuning opportunities than annealed SiON:H, where the loss-lowering procedure determines the temperature history and hence the residual stress.

It has to be noted that the new method also offers the advantages already present when using annealed SiON:H material, namely eliminating N-H loss (cf. Fig. 2; lower curve), thus opening a wider wavelength window for SiON photonic ICs, realization of radius of curvature of as small as 1.5 mm, etc., associated with the high refractive index of SiON.

As compared to the state of the art processes already mentioned before, the method according to the invention does not change the starting materials by replacing hydrogen with deuterium but starts already using deuterated gaseous precursors, namely SiD₄ and/or ND₃. The work performed proves that the largest contribution to the conventional N-H loss at 1510 nm originates from the N-H precursor. Starting the process using ND₃ as a precursor lowers the loss to the annealed, conventional value of SiON:H. Using both hydrogenated presursors, SiD₄ and ND₃. lowers the loss >5x over the conventionally annealed SiON:H material. It has to be mentioned that only small deuterated gas-volumes are consumed and thus the process is very cost-effective. The present plasma deposition process consumes per full SiON:D core 4" wafer three liters of ND₃ and 30 liters of 2% SiD₄ (diluted in He), thsi implies about 330 full 4" SiON:D wafers from a standard gas cylinder.

The incorporation of nitrogen, "N-doping", has a far stronger effect on refractive index than B-, P- or Ge-doping, because the N-doping continuously changes the host material, in contrast to light additives as B, P or Ge. The effect of nitrogen on the refractive index is about 10x stronger and thus an adequate optical "bending" into a 1.5 mm radius is obtained at a nitrogen atomic content of 8.0 +/- 1 % N at a refractive index of 1.510. The preferred range of nitrogen is about 3 to about 15 atomic %; the 3% lower limit gives some advantage in waveguide radius over conventional Ge:SiO₂ and is easily detectable, the 15% as a high limit will give a radius of about 0.5 mm.

The preferred composition in relative atomic fractions [%] of the SiON:D material is as follows, with, e.g., the "N atomic fraction" being the amount of N atoms divided by the sum of the sum of Si, O and N atoms.

| Element | Fraction |
|---|---|
| Si | 10 |
| O | 19 |
| N | 0.05 - 0.10 |
| D | 0.05 - 0.15 |
| H | < 0.01 |

As has been previously mentioned, either one or both precursors for the manufacture of SiON waveguides, namely NH₃ and SiH₄, can be deuterated. Five precursor mixtures have been used in the evaluation of infrared absorption and optical loss. The following table gives the improvement factors as compared to the standard-annealed hydrogenated SiON:H material (M1).

| | Mixture | Improvement | Remarks |
|---|---|---|---|
| M1 | SiH₄/NH₃/N₂O | -- | Reference SiON |
| M2 | SiD₄/ND₃/N₂O | 5-7x | All deuterated |
| M3 | SiH₄/ND₃/N₂O | Marginal | SiH₄ and N₂O |
| M4 | SiD₄/--/N₂O | Marginal | Other Chemistry |
| M5 | SiD₄/NH₃/N₂O | None | Contains NH₃ |

"Other chemistry" in M4 indicates there is not the usual plasma chemistry using SiH/NH/NO (or its D-isotopes), but rather SiH/NO without NH; thus the chemical reaction or synthesis routes are different.

This indicates that by far the largest contribution of N-H in SiON:H originates from the NH₃ gas in the current SiH₄/NH₃/N₂O mixture.

Improvement in optical loss at 1510 nm by a factor 5 to 7 is obtained with the set M2 without annealing, compared to the standard SiON:H hydrogenated results after annealing. Loss figures in dB/cm are compared in the following table (cf. Also Fig. 2).

| Process | | Loss @ 1510 nm | Loss @ 1540 nm |
|---|---|---|---|
| Standard | SiON:H | 1.0 ± 0.2 | 0.13 ± 0.02 |
| M2 | SiON:D | 0.16 ± 0.02 | 0.07 ± 0.02 |

The method according to the invention comprises the following steps:
A) Oxidation of silicon wafer to a defined thickness by oxygen diffusion at high temperature;
B) Deposition on SiON waveguide layer by Plasma-CVD;
C) Definition of ridge structure via lithography and etching in the SiON core layer;
D) Overgrowth of core/ridge structure ith SiO₂ by Plasma-CVD or by thermal CVD;
E) Densification of the overgrowth layer to adjust birefringence; and
F) Dicing of wafer into individual chips and polishing of optical input/output facets of the individual devices.

Fig. 3 shows the compressive stress as a function of temperature. It can be seen that the material according to the invention (SiON:D) has a significantly lower value of stress than the conventionally produced material (SiON:H).

In Fig. 4 there is provided a plot of the estimated dependence of birefringence on the compressive stress in a waveguide. Given a value of about -80 MPa for the material according to the invention, it is clearly perceptible that the resulting birefringence is drastically decreased.

The outstanding advantage of the proposed method is the complete elimination of N-H related absorption in SiON leading to ultra- low loss material with a wide optical bandwidth. The proposed technique is a low-cost, mass-fabrication technology when implemented in PECVD for two reasons: (i) small deuterated gas-volumes are consumed and (ii) expensive manufacturing processing steps like high-temperature annealing are eliminated. Thus, a faster wafer turnaround time is obtained.

The avoidance of the anneal cycle simplifies the process workflow and gives a wider process latitude as it allows the use of a wider temperature window, allowing the design of other cladding/sintering treatments (densification) to even further lower the stress-related effects. The new process latitude is used to deliberately optimize a moderate temperature cycling for stress adjustment and for the first time offers the possibility to integrate the optical waveguides into a conventional CMOS process for further hybrid integration. Applications could be optical clock distribution, optical receiver or power drivers for thermal tuning.

## Claims

1. Method for fabricating planar optical waveguides based on silicon oxinitride (SiON) material by means of a PECVD process,
**characterized in that**
deuterated gaseous precursors are used as starting materials, and the maximum temperature reached during the process steps is in the range of about 550 to about 850°C.

2. Method according to claim 1, wherein the higher value of the temperature range is only reached in case a densification of the obtained SiON material is necessary.

3. Method according to claim 2, wherein the deuterated gaseous precursors are SiD₄ and ND₃.

4. Method according to claim 3, wherein only one of said deuterated precursors is used.

5. Method according to claim 3, wherein both of the gaseous precursors are used.

## Patentansprüche

1. Verfahren zur Herstellung planarer Lichtwellenleiter auf der Basis von Siliziumoxynitrid (SiON) über einen PECVD-(Plasma Enhanced Chemical Vapor Deposition)Prozess,
**dadurch gekennzeichnet, dass**
als Ausgangsmaterialien deuterierte gasförmige Vorprodukte verwendet werden, und die Maximaltemperatur, die während der Prozessschritte erreicht wird, im Bereich von etwa 550°C bis etwa 850°C liegt.

2. Verfahren nach Anspruch 1, wobei der höhere Wert des Temperaturbereichs nur in dem Fall erreicht wird, dass eine Verdichtung des erhaltenen SiON-Materials notwendig ist.

3. Verfahren nach Anspruch 2, wobei die deuterierten gasförmigen Vorprodukte SiD₄ und ND₃ sind.

4. Verfahren nach Anspruch 3, wobei nur eines der deuterierten Vorprodukte verwendet wird.

5. Verfahren nach Anspruch 3, wobei beide gasförmigen Vorprodukte verwendet werden.

## Revendications

1. Procédé permettant de fabriquer des guides d'onde optiques plans sur un matériau à base d'oxi-azoture de silicium (SiON) au moyen d'un procédé de déposition chimique en phase gazeuse enrichie en plasma (PECVD),
**caractérisé en ce que**
des précurseurs gazeux deutérisés sont utilisés comme matériaux d'origine, et que la température maximale atteinte pendant les phases de traitement est comprise entre 550 et 850°C environ.

2. Procédé selon la revendication 1, où la valeur la plus élevée de la gamme des températures n'est atteinte que dans le cas où une densification du matériau SiON obtenu est nécessaire.

3. Procédé selon la revendication 2, où les précurseurs gazeux deutérisés sont SiD₄ et ND₃.

4. Procédé selon la revendication 3, où un seul desdits précurseurs deutérisés est utilisé.

5. Procédé selon la revendication 3, où les deux précurseurs gazeux sont utilisés.
